# EUROPEAN PATENT APPLICATION

(11) **EP 2 302 463 A1**
(43) Date of publication of application: **30.03.2011**
(21) Application number: 10178710.9
(22) Date of filing: 23.09.2010
(51) Int. Cl.: G03F 7/32, B41C 1/00

(54) **Method of preparing a lithographic printing plate**

(30) Priority: 24.09.2009 JP 2009219715
(71) Applicant: Fujifilm Corporation, Minato-ku Tokyo (JP)
(72) Inventor: Arimura, Keisuke, Shizuoka (JP)
(74) Representative: HOFFMANN EITLE

(57) **Abstract**

A method of preparing a lithographic printing plate , which comprises: an exposing step of exposing with laser a lithographic printing plate precursor comprising a hydrophilic support having provided thereon a photosensitive layer containing (A) a hexaarylbisimidazole compound, (B) a polymerizable compound having a photo-oxidizable group, (C) a sensitizing dye and (D) a binder polymer, and a protective layer in this order; a developing step of removing the protective layer and an unexposed area of the photosensitive layer of the lithographic printing plate precursor in the presence of a developer containing an organic solvent having a boiling point of 100°C or higher and an octanol-water partition coefficient of 3.0 or less and at least one of a surfactant and a water-soluble polymer compound; and a drying step of drying the lithographic printing plate precursor by heating at a plate surface temperature in a range of 30 to 80°C, wherein a water washing step is not included between the developing step and the drying step.

## Description

### Background of the invention

### 1. Field of the Invention

The present invention relates to a method of preparing a lithographic printing plate.

### 2. Description of the Related Art

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

Thus, in the hitherto known plate making process of lithographic printing plate precursor, after exposure, the step of removing the unnecessary portion of the image-recording layer by dissolving, for example, with a developer is required. However, in view of the environment and safety, to make a processing with a developer closer to a neutral range possible and to reduce an amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous alkali solution having pH of 11 or more, washing of the alkali agent with a water-washing bath and then treating with a gum solution mainly comprising a hydrophilic resin as described above, an automatic development processing apparatus per se requires a large space and problems of the environment and running cost, for example, disposal of the development waste liquid, water-washing waste liquid and gum waste liquid still remain.

In response to the above situation, for instance, a method of preparing a lithographic printing plate including a developing method of processing with a developer having pH of 8.5 to 11.5 and a dielectric constant of 3 to 30 mS/cm and containing an alkali metal carbonate and an alkali metal hydrogen carbonate is proposed in Patent Document 1. However, since the method is required a water-washing step and a treatment step with a gum solution, it does not resolve the problems of the environment and running cost.

Also, a method of preparing a lithographic printing plate including processing with a processing solution having pH of 11.9 to 12.1 and containing a water-soluble polymer compound is described in Patent Document 2. However, since the lithographic printing plate obtained by the processing is left in the state that the alkali of pH 12 adheres on the surface thereof, a problem in view of safety of an operator arises and also another problem occurs in that with the lapse of long time after the preparation of the lithographic printing plate until the initiation of printing, the image area gradually dissolves to result in deterioration in printing durability or ink-receptive property.

In Patent Document 3, a method of preparing a lithographic printing plate including processing with a processing solution having pH of 3 to 9 and containing a water-soluble polymer compound is described. However, since the processing solution does not contain a basic component, it is necessary to enable development by making a polymer used in the photosensitive layer hydrophilic and thus, a problem occurs in that printing durability severely degrades.

On the other hand, a method of preparing a lithographic printing plate including development processing using a developer other than a strongly alkaline developer to remove a protective layer and the unexposed area of a photosensitive layer in only one developing tank (by one bath) without accompanying a water washing step is known (see, for example, Patent Document 4). However, since the method includes the development with a weak alkaline developer, solubilities of a polymerizable compound and a binder polymer are insufficient and when the development is continuously conducted, development scum may occur in some cases.

Further, as a means for obtaining high printing durability, it is described to use a hexaarylbisimidazole compound as a polymerization initiator and a polymerizable compound having a photo-oxidizable group as a photopolymerizable monomer in a photosensitive layer of a lithographic printing plate precursor (see Patent Document 5).
[Patent Document 1] JP-A-11-65126 (the term "JP-A" as used herein means an "unexamined published Japanese patent application")
[Patent Document 2] EP-A-1868036
[Patent Document 3] JP-T-2007-538279 (the term "JP-T" as used herein means a published Japanese translation of a PCT patent application)
[Patent Document 4] WO 2007/057336
[Patent Document 5] JP-T-2007-506125

### Summary of the Invention

As a result of the investigations according to the present inventors, it has been found that when the lithographic printing plate precursor using the polymerization initiator and monomer described in Patent Document 5 is subjected to development processing by one bath, a problem arises in that since these compounds are very poor in solubility or dispersibility in a developer of an acidic to weak alkaline range, as the amount of development processing increases and the amount of the component dissolved in the developer increases, the solubility or dispersibility is deteriorated so that the development scum is easily apt to occur.

On the other hand, the solubility or dispersibility may be increased by adding an organic solvent to the developer. However, since this causes odor generation, a problem of severe degradation of working environment arises and thus the attention to environment and the adaptation of space saving and low running cost have not been yet achieved.

Therefore, an object of the present invention is to provide a method of preparing a lithographic printing plate which prevents the occurrence of development scum, achieves a balance between good developing property and good printing durability, is free from the odor generation, and satisfies the attention to environment and the adaptation of space saving and low running cost, even when development with a developer of an acidic to weak alkaline range is conducted.

As a result of the intensive investigations to solve the problems, the inventors have found that the good developing property and good printing durability are achieved, a water washing step is eliminated and the odor generation is prevented by applying a developer containing an organic solvent having a specific octanol-water partition coefficient to a lithographic printing plate precursor having a specific photosensitive layer to complete the present invention.

Specifically, the object of the present invention can be achieved by the means described below.
(1) A method of preparing a lithographic printing plate , which comprises:
   an exposing step of exposing with laser a lithographic printing plate precursor comprising a hydrophilic support having provided thereon a photosensitive layer containing (A) a hexaarylbisimidazole compound, (B) a polymerizable compound having a photo-oxidizable group, (C) a sensitizing dye and (D) a binder polymer, and a protective layer in this order,
   a developing step of removing the protective layer and an unexposed area of the photosensitive layer of the lithographic printing plate precursor in the presence of a developer containing an organic solvent having a boiling point of 100°C or higher and an octanol-water partition coefficient of 3.0 or less and at least one of a surfactant and a water-soluble polymer compound, and
   a drying step of drying the lithographic printing plate precursor by heating at a plate surface temperature in a range of 30 to 80°C,
   wherein a water washing step is not included between the developing step and the drying step.
(2) The method of preparing a lithographic printing plate according to the above (1), wherein a pH of the developer is from 2 to 11.
(3) The method of preparing a lithographic printing plate according to the above (1) or (2), wherein the developer further contains a carbonate ion and a hydrogen carbonate ion.
(4) The method of preparing a lithographic printing plate according to the above (1) or (2), wherein the developer further contains a water-soluble organic amine compound and an ion of the water-soluble organic amine compound.
(5) The method of preparing a lithographic printing plate according to the above (4), wherein the water-soluble organic amine compound is at least one organic amine compound selected from the group consisting of monoethanolamine, diethanolamine, triethanolamine, N-hydroxyethylmorpholine and 4-dimethylaminopyridine.
(6) The method of preparing a lithographic printing plate according to any one of the above (1) to (5), wherein the organic solvent is an alcohol.
(7) The method of preparing a lithographic printing plate according to any one of the above (1) to (5), wherein the organic solvent is an ester.
(8) The method of preparing a lithographic printing plate according to any one of the above (1) to (5), wherein the organic solvent is an amido-group containing compound.
(9) The method of preparing a lithographic printing plate according to any one of the above (1) to (5), wherein the organic solvent is a sulfur-containing compound.
(10) The method of preparing a lithographic printing plate according to any one of the above (1) to (9), wherein an amount of the organic solvent is from 0.001 to 2.0% by weight in the developer.
(11) The method of preparing a lithographic printing plate according to any one of the above (1) to (10), wherein (D) the binder polymer is a polyvinyl butyral resin.

The method of preparing a lithographic printing plate according to the invention prevents the occurrence of development scum, achieves a balance between good developing property and good printing durability, is free from the odor generation, and satisfies the attention to environment and the adaptation of space saving and low running cost, even when development with a developer of an acidic to weak alkaline range is conducted.

Specifically, since the method of preparing a lithographic printing plate according to the invention does not contain a water washing step between the developing step and the drying step, the development processing can be conducted by a small-size development processing apparatus to achieve space saving and to reduce running cost. Further, by incorporating the specific organic solvent into the developer, the solubility or dispersibility of the photosensitive layer containing the hexaarylbisimidazole compound and polymerizable compound having a photo-oxidizable group in the developer is increases, whereby the development scum hardly occurs in the development processing of the lithographic printing plate precursor. Moreover, by using the specific organic solvent, the generation of odor is prevented even when the lithographic printing plate having the developer attached thereon is dried without performing a water washing step.

### Brief Description of the Drawing

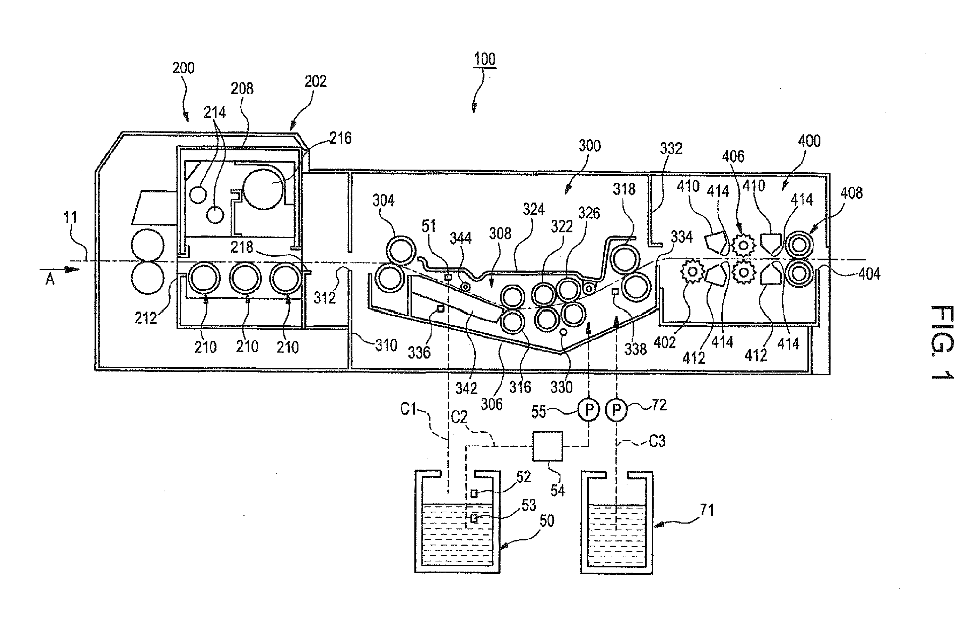

Fig. 1 is a perspective side view schematically showing an internal structure of an automatic development processing apparatus used in the method of preparing a lithographic printing plate according to the invention.

### Description of Reference Numerals and Signs

100: Automatic development processing apparatus
200: Pre-heating unit
300: Developing unit
400: Drying unit

### Detailed Description of the Invention

The present invention will be described in detail hereinafter.

First, a lithographic printing plate precursor for use in the method of preparing a lithographic printing plate according to the invention is described below.

### [Lithographic printing plate precursor]

The lithographic printing plate precursor for use in the method of preparing a lithographic printing plate according to the invention comprises a hydrophilic support having thereon a specific photosensitive layer and a protective layer in this order.

The specific photosensitive layer contains (A) a hexaarylbisimidazole compound, (B) a polymerizable compound having a photo-oxidizable group, (C) a sensitizing dye and (D) a binder polymer. The specific photosensitive layer may further contain other components, if desired.

### <Photosensitive layer>

### (A) Hexaarylbisimidazole compound (polymerization initiator)

The hexaarylbisimidazole compound for use in the invention is employed as a polymerization initiator.

The hexaarylbisimidazole compound includes, for example, lophine dimers described in JP-B-45-37377 (the term "JP-B" as used herein means an "examined Japanese patent publication") and JP-B-44-86516, specifically, 2,2'-bis(o-chlorophenyl)-4,4',5,5'-tetraphenylbisimidazole, 2,2'-bis(o-bromophenyl)-4,4',5,5'-tetraphenylbisimidazole, 2,2'-bis(o,p-dichlorophenyl)-4,4',5,5'-tetraphenylbisimidazole, 2,2'-bis(o-chlorophenyl)-4,4',5,5'-tetra(m-methoxyphenyl)bisimidazole, 2,2'-bis(o,o'-dichlorophenyl)-4,4',5,5'-tetraphenylbisimidazole, 2,2'-bis(o-nitrophenyl)-4,4',5,5'-tetraphenylbisimidazole, 2,2'-bis(o-methylphenyl)-4,4',5,5'-tetraphenylbisimidazole and 2,2'-bis(o-trifluoromethylphenyl)-4,4',5,5'-tetraphenylbisimidazole.

The hexaarylbisimidazole compounds may be used individually or in combination of two or more thereof.

The amount of the hexaarylbisimidazole compound used in the photosensitive layer is preferably from 0.01 to 20% by weight, more preferably from 0.1 to 15% by weight, still more preferably from 1.0 to 10% by weight, based on the total solid content of the photosensitive layer from the standpoint of sensitivity and preservation stability.

In the photosensitive layer according to the invention, other polymerization initiator may be used together with the hexaarylbisimidazole compound.

As the other polymerization initiator, polymerization initiators known to those skilled in the art can be used without limitation. Specifically, for example, a trihalomethyl compound, a carbonyl compound, an organic peroxide, an azo compound, an azide compound, a metallocene compound, an organic boron compound, a disulfone compound, an oxime ester compound, an onium salt compound and a iron arene complex are exemplified.

In addition, polymerization initiators described in JP-A-2007-171406, JP-A-2007-206216, JP-A-2007-206217, JP-A-2007-225701, JP-A-2007-225702, JP-A-2007-316582 and JP-A-2007-328243 may be used.

The amount of the other polymerization initiator used in the photosensitive layer is preferably 50 parts by weight or less, more preferably 20 parts by weight or less, based on 100 parts by weight of the hexaarylbisimidazole compound.

### (B) Polymerizable compound having photo-oxidizable group

The polymerizable compound having a photo-oxidizable group (B) for use in the invention has at least one polymerizable group and at least one photo-oxidizable group.

The photo-oxidizable group is an amino group which may be a constituting component of a hetero ring, a urea group, a thio group or an enol group. Specific examples of the photo-oxidizable group include a triethanolamino group, a triphenylamino group, a thiourea group, an imidazole group, an oxazole group, a thiazolimidazole group, an acetylacetonitrileimidazole group, an N-phenylglycineimidazole group and an ascorbic acid group. The amino group may be a primary, secondary or tertiary amino group and is preferably a tertiary amino group.

The polymerizable group is not particularly restricted and is preferably a group containing an ethylenically unsaturated double bond.

The polymerizable compound has a chemical form, for example, a monomer, a prepolymer, specifically, a dimer, a trimer or an oligomer, or a mixture thereof.

Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used.

An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used.

Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used.

In addition, compounds in which the unsaturated carboxylic acid described above is replaced by an unsaturated phosphonic acid, styrene, vinyl ether or the like can also be used.

The polymerizable compound having a photo-oxidizable group preferably further has a urethane group. Specific examples of such polymerizable compound include those described in JP-A-63-260909, Japanese Patent 2669849, JP-A-6-35189, JP-A-2001-125255, JP-T-2007-506125 and WO 2007/072689.

The compounds shown below are also preferably used.

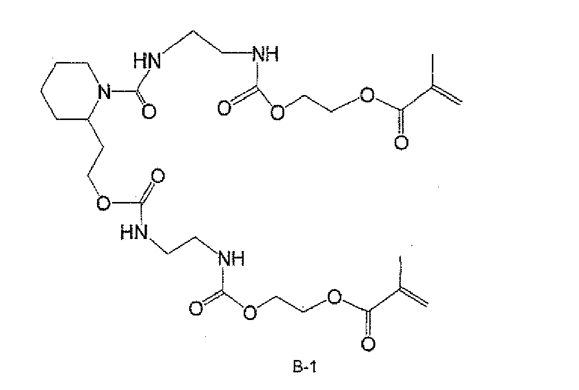

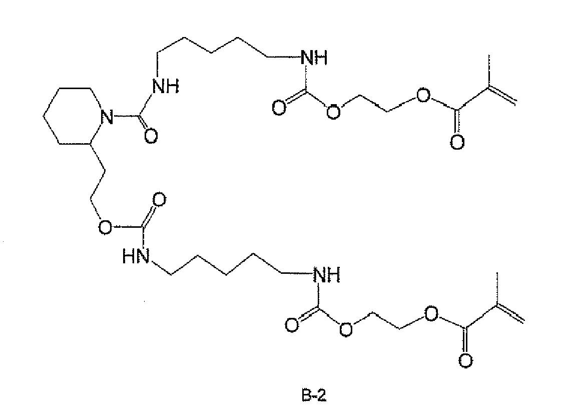

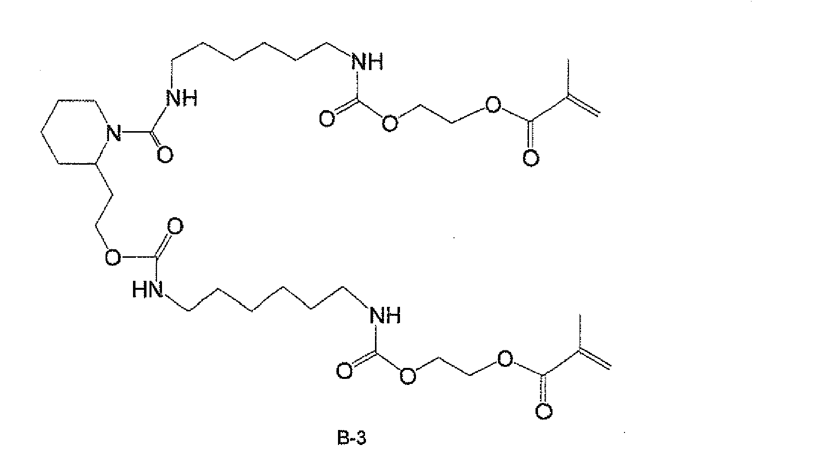

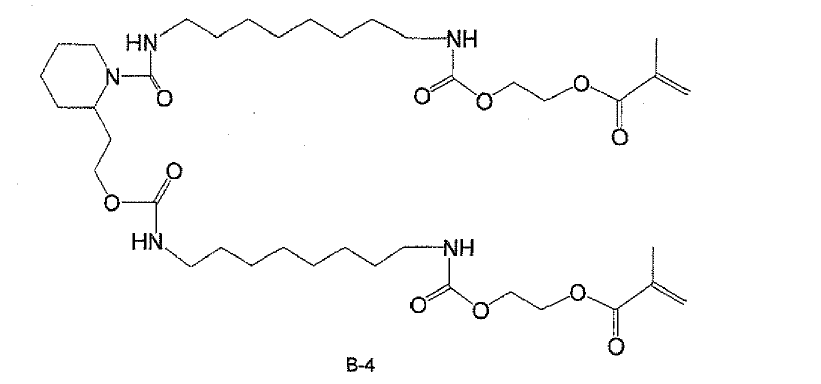

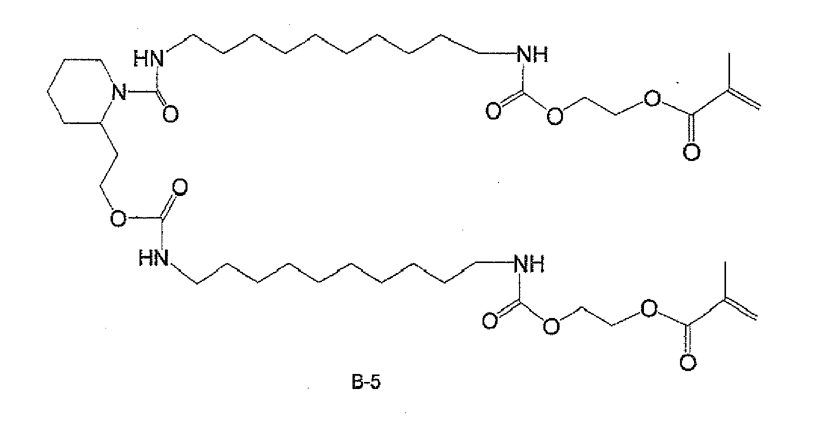

Details of the method of using the polymerizable compound, for example, selection of the structure, individual or combination use or an amount added, can be appropriately determined in accordance with the characteristic design of the final lithographic printing plate precursor.

The amount of the polymerizable compound used is preferably in a range of 5 to 75% by weight, more preferably in a range of 25 to 70% by weight, still more preferably in a range of 30 to 60% by weight, based on the total solid content of the photosensitive layer.

In order to obtain high sensitivity, a radical chain transfer agent as described in European Patent 107,792 may be added to the photosensitive layer. As the chain transfer agent, for example, compounds having SH, PH, SiH or GeH in their molecules are used. The compound donates hydrogen to a low active radical species to generate a radical or is oxidized and then deprotonized to generate a radical. Preferable examples of the chain transfer agent include sulfur-containing compounds. In particular, a thiol compound, for example, a 2-mercaptobenzothiazole, a 2-mercaptobenzoxazole or a 2-mercaptobenzimidazole is preferably exemplified. The amount of the chain transfer agent is preferably in a range of 0.01 to 10% by weight, more preferably in a range of 0.1 to 2% by weight, based on the solid content of the photosensitive layer.

### (C) Sensitizing dye

The photosensitive layer according to the invention contains a sensitizing dye.

By incorporating a sensitizing dye having an absorption maximum in a wavelength range of 350 to 450 nm, a sensitizing dye having an absorption maximum in a wavelength range of 500 to 600 nm or an infrared absorbing agent having an absorption maximum in a wavelength range of 750 to 1,400 nm, as the sensitizing dye into the photosensitive layer, a lithographic printing plate precursor of high sensitivity responding to a violet laser of 405 nm, a green laser of 532 nm or an IR laser of 830 nm can be provided.

First, the sensitizing dye having an absorption maximum in a wavelength range of 350 to 450 nm is described below.

Examples of such sensitizing dye include merocyanine dyes, benzopyranes, coumarins, aromatic ketones and anthracenes.

Of the sensitizing dyes having an absorption maximum in a wavelength range of 350 to 450 nm, a dye represented by formula (IX) shown below is more preferred in view of high sensitivity.

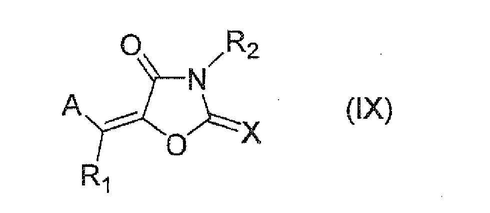

In formula (IX), A represents an aromatic cyclic group which may have a substituent or a heterocyclic group which may have a substituent, X represents an oxygen atom, a sulfur atom or N(R₃), and R₁, R₂ and R₃ each independently represents a monovalent non-metallic atomic group, or A and R₁ or R₂ and R₃ may be combined with each other to form an aliphatic or aromatic ring.

The formula (IX) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atoms.

A represents an aromatic cyclic group which may have a substituent or a heterocyclic group which may have a substituent.

Specific examples of the sensitizing dye include compounds described in Paragraph Nos. [0047] to [0053] of JP-A-2007-58170.

Further, a sensitizing dye represented by formula (V) or (VI) shown below can also be used.

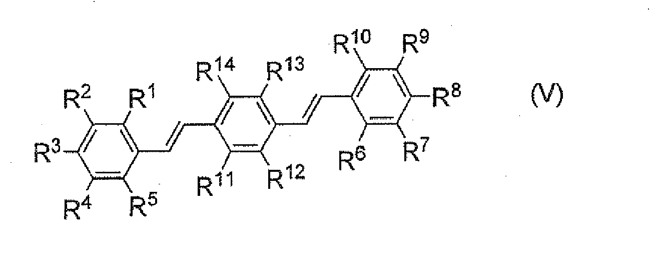

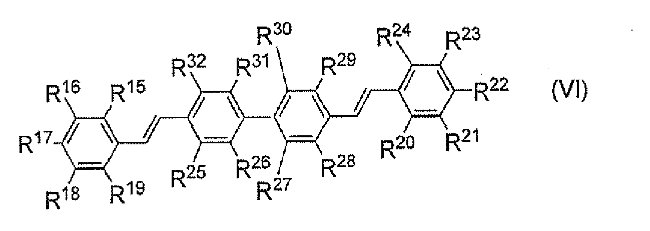

In formula (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (VI), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

As specific examples of such sensitizing dye, compounds described in EP-A-1349006 and WO 2005/029187 are exemplified.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also used.

The amount of the sensitizing dye having an absorption maximum in a wavelength range of 350 to 450 nm added is preferably from 0.05 to 30 parts by weight, more preferably from 0.1 to 20 parts by weight, most preferably from 0.2 to 10 parts by weight, based on 100 parts by weight of the total solid content of the photosensitive layer.

Next, the sensitizing dye having an absorption maximum in a wavelength range of 750 to 1,400 nm is described in detail below.

Such a sensitizing dye includes an infrared absorbing agent and it is believed that the sensitizing dye forms an electron excited state with high sensitivity upon irradiation (exposure) of infrared laser, and electron transfer, energy transfer or heat generation (light-to-heat conversion function) relating to the electron excited state acts on a polymerization initiator coexistent in the photosensitive layer to cause chemical change in the polymerization initiator, thereby generating a radical.

In any event, it is particularly preferable for plate making including direct drawing with the infrared laser beam having a wavelength of 750 to 1,400 nm to add the sensitizing dye having an absorption maximum in a wavelength range of 750 to 1,400 and the high image-forming property can be generated in comparison with a conventional lithographic printing plate precursor.

The infrared absorbing agent is preferably a dye or pigment having an absorption maximum in a wavelength range of 750 to 1,400 nm.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

### Formula (a)

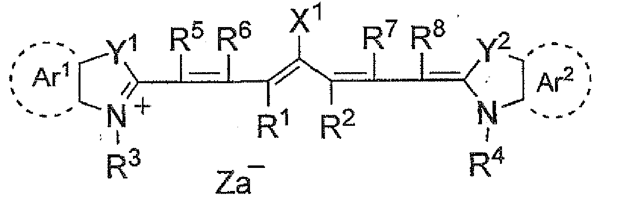

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. Xa⁻ has the same meaning as Za⁻ defined hereinafter. R^{a} represents a hydrogen atom or a substituent selected from an alkyl group, an aryl group, a substituted or unsubstituted amino group and a halogen atom.

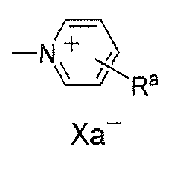

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms and it is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms, Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (a) has an anionic substituent in the structure thereof and the neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a) which can be preferably used in the invention include those described in Paragraph Nos. [0017] to [0019] of JP-A-2001-133969.

Further, other particularly preferable examples of the dye include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

The amount of the sensitizing dye having an absorption maximum in a wavelength range of 750 to 1,400 nm added is preferably in a range from 0.05 to 30% by weight, more preferably from 0.1 to 20% by weight, most preferably from 0.2 to 10% by weight, based on 100 parts by weight of the total solid content of the photosensitive layer.

### (D) Binder polymer

As the binder polymer for use in the photosensitive layer according to the invention, a polymer capable of holding the components of photosensitive layer on a support and capable of being removed by a developer is used. The binder polymer used includes a (meth)acrylic polymer, a polyurethane resin, a polyvinyl alcohol resin, a polyvinyl butyral resin, a polyvinyl formal resin, a polyamide resin, a polyester resin and an epoxy resin. A (meth)acrylic polymer, a polyurethane resin or a polyvinyl butyral resin is preferred and a polyvinyl butyral resin is more preferred. By using a polyvinyl butyral resin having a hydrophilic group as the binder polymer, the generation of development scum can be more restrained.

The term "(meth)acrylic polymer" as used herein means a copolymer containing as a polymerization component, (meth)acrylic acid or a (meth)acrylic acid derivative, for example, a (meth)acrylate (including, for example, an alkyl ester, an aryl ester and an allyl ester), (meth)acrylamide or a (meth)acrylamide derivative. The term "polyurethane resin" as used herein means a polymer formed by a condensation reaction of a compound having two or more isocyanate groups and a compound having two or more hydroxy groups. The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and also includes a polymer wherein an acid group or the like is introduced, for example, by a method of reacting the remaining hydroxy group with a compound having the acid group or the like.

One preferable example of the binder polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferred. As the repeating unit, a repeating unit derived from (meth)acrylic acid or a repeating unit represented by formula (I-A) shown below is preferably used.

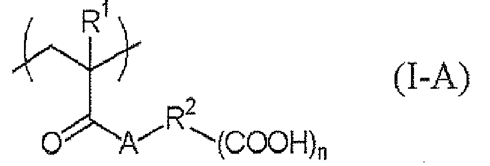

In formula (I-A), R¹ represents a hydrogen atom or a methyl group, R² represents a single bond or an n+1 valent connecting group, A represents an oxygen atom or -NR³-, wherein R³ represents a hydrogen atom or a monovalent hydrocarbon group having from 1 to 10 carbon atoms, and n represents an integer of 1 to 5.

The connecting group represented by R² in formula (I-A) is constructed from a carbon atom, a hydrogen atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via an amido bond or an ester bond. R² is preferably a single bond, an alkylene group or a substituted alkylene group, more preferably a single bond, an alkylene group having from 1 to 5 carbon atoms or a substituted alkylene group having from 1 to 5 carbon atoms, and most preferably a single bond, an alkylene group having from 1 to 3 carbon atoms or a substituted alkylene group having from 1 to 3 carbon atoms.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, more preferably a hydrogen atom or a hydrocarbon group having from 1 to 3 carbon atoms, and most preferably a hydrogen atom or a methyl group. n is preferably from 1 to 3, more preferably 1 or 2, and most preferably 1.

A ratio (% by mol) of the copolymerization component having a carboxylic acid group in the total copolymerization components of the binder polymer is preferably from 1 to 70% in view of developing property. Considering good compatibility between the developing property and printing durability, it is more preferably from 1 to 50%, and particularly preferably from 1 to 30%.

Examples of the binder polymer having an acid group include copolymers of (meth)acrylic acid and a (meth)acrylate (for example, an alkyl ester having from 1 to 5 carbon atoms).

Further, a polyvinyl butyral resin having an acid group introduced, for example, a resin represented by formula (I-B) shown below is also preferably used.

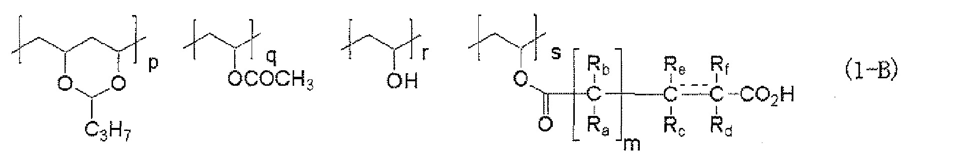

In formula (I-B), a ratio of each repeating unit p/q/r/s is preferably in a range from 50 to 78% by mol/from 1 to 5% by mol/from 5 to 28% by mol/from 5 to 20% by mol. Rₐ and R_{b} each independently represents a hydrogen atom, a monovalent substituent which may have a substituent, R_{c}, R_{d}, Rₑ and R_{f} each independently represents a hydrogen atom, a monovalent substituent which may have a substituent or a single bond, and m represents 0 or 1. Preferable examples of the monovalent substituent represented by any one of Rₐ, R_{b}, R_{c}, R_{d}, Rₑ and R_{f} include an alkyl group which may have a substituent, a halogen atom and an aryl group which may have a substituent. More preferable examples thereof include a straight-chain alkyl group, for example, a methyl group, an ethyl group or a propyl group, an alkyl group substituted with a carboxylic acid, a halogen atom, a phenyl group and a phenyl group substituted with a carboxylic acid. R_{c} and R_{d} or Rₑ and R_{f} may form a ring structure. The bond between the carbon atom to which R_{c} and Rₑ connect and the carbon atom to which R_{d} and R_{f} connect is a single bond, a double bond or an aromatic double bond and in the case of the double bond or aromatic double bond, R_{c} and R_{d}, Rₑ and R_{f}, R_{c} and R_{f} or Rₑ and R_{d} are connected with each other to from a single bond.

Preferable specific examples of the repeating unit having a carboxylic acid group are set forth below.

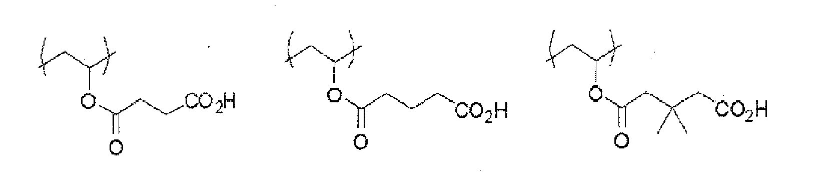

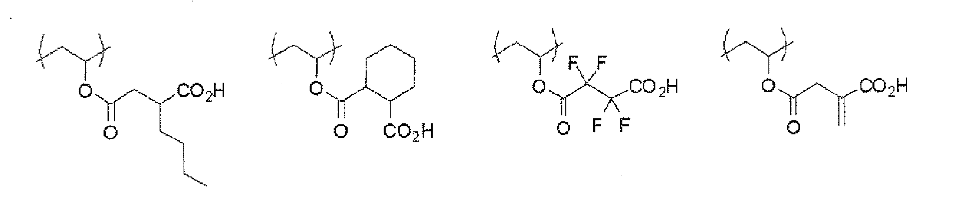

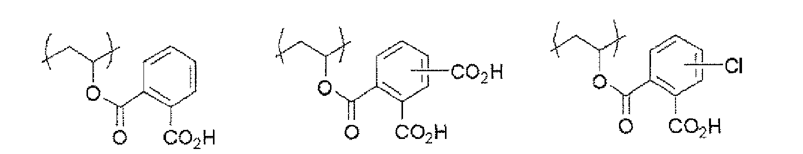

Moreover, the acid group of a polymer having an acid group which is a preferable example of the binder polymer according to the invention may be neutralized with a basic compound. Particularly, it is preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

It is preferred that the binder polymer for use in the invention further contains a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, most preferably from 0.1 to 2.0 mmol, per g of the binder polymer.

The binder polymer for use in the invention may contain a polymerization unit of alkyl (meth)acrylate or aralkyl (meth)acrylate besides the polymerization unit having an acid group and the polymerization unit having a crosslinkable group. The alkyl group in the alkyl (meth)acrylate is preferably an alkyl group having from 1 to 5 carbon atoms and more preferably a methyl group. The aralkyl (meth)acrylate includes, for example, benzyl (meth)acrylate.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer from the standpoint of good strength of the image area and good image-forming property.

The total content of the polymerizable compound and the binder polymer is preferably 80% by weight or less based on the total solid content of the photosensitive layer. When it exceeds 80% by weight, decrease in the sensitivity and deterioration in the developing property may be caused sometimes. The total content is more preferably from 35 to 75% by weight.

According to the invention, by controlling a ratio of the polymerizable compound and the binder polymer contained in the photosensitive layer of the lithographic printing plate precursor, the permeability of developer into the photosensitive layer more increases and the developing property is further improved. Specifically, a weight ration of polymerizable compound/binder polymer in the photosensitive layer is preferably 1.2 or more, more preferably from 1.25 to 4.5, and most preferably from 2 to 4.

### (Other components for photosensitive layer)

Into the photosensitive layer, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity and a plasticizer for improving plasticity. As the additives, known compounds are used and, for example, compounds described in Paragraph Nos. [0161] to [0215] of JP-A-2007-206217 are used.

### <Formation of photosensitive layer>

The photosensitive layer is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer on the support after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### <Protective layer>

In the lithographic printing plate precursor for use in the method of preparing a lithographic printing plate according to the invention, a protective layer (oxygen-blocking layer) is provided on the photosensitive layer in order to prevent diffusion and penetration of oxygen which inhibits the polymerization reaction at the time of exposure. As a material used in the protective layer, for example, a water-soluble polymer compound relatively excellent in crystallizability is preferably used. Specifically, when polyvinyl alcohol is used as a main component, the best results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and solubility in water. Also, polyvinyl alcohol may partly have other copolymer component. Polyvinyl alcohol is obtained by hydrolysis of polyvinyl acetate. As specific examples of the polyvinyl alcohol, those having a hydrolysis degree of 71 to 100% by mol and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, and more preferably from 30 to 90% by weight.

Also, known modified polyvinyl alcohol can be preferably used. Particularly, an acid-modified polyvinyl alcohol having a carboxylic acid group or a sulfonic acid group is preferably used. As a component used as a mixture with polyvinyl alcohol, polyvinyl pyrrolidone or a modified product thereof is preferred from the viewpoint of the oxygen-blocking property and removability by development. The content thereof is ordinarily from 3.5 to 80% by weight, preferably from 10 to 60% by weight, more preferably from 15 to 30% by weight, in the protective layer.

As other component of the protective layer, glycerin, dipropylene glycol or the like can be added in an amount corresponding to several % by weight of the water-soluble polymer compound to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount corresponding to several % by weight of the water-soluble polymer compound.

Further, it is also preferred to incorporate an inorganic stratiform compound described in Paragraph Nos. [0018] to [0024] of JP-A-2006-106700 into the protective layer for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful.

The coating amount of the protective layer is preferably in a range of 0.05 to 10 g/m² in terms of the coating amount after drying. When the protective layer contains the inorganic stratiform compound, it is more preferably in a range of 0.1 to 5 g/m², and when the protective layer does not contain the inorganic stratiform compound, it is more preferably in a range of 0.5 to 5 g/m².

### <Hydrophilic support>

A support for use in the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.

The center line average roughness of hydrophilic support is preferably from 0.10 to 1.2 µm. In the range described above, good adhesion property to the photosensitive layer, good printing durability and good resistance to stain are achieved.

The color density of the hydrophilic support is preferably from 0.15 to 0.65 in terms of the reflection density value. In the range described above, good image-forming property by preventing halation at the image exposure and good aptitude for plate inspection after development are achieved.

The thickness of the hydrophilic support is preferably from 0.1 to 0.6 mm, more preferably from 0.15 to 0.4 mm, and still more preferably from 0.2 to 0.3 mm.

### <Hydrophilizing treatment of support and undercoat layer>

According to the invention, in order to increase hydrophilicity of the non-image area and to prevent printing stain, it is preferred to conduct hydrophilizing treatment of the surface of hydrophilic support or to provide an undercoat layer between the hydrophilic support and the photosensitive layer.

The hydrophilizing treatment of the surface of hydrophilic support includes an alkali metal silicate treatment wherein the hydrophilic support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

As the undercoat layer, an undercoat layer containing a compound having an acid group, for example, a phosphonic acid group, a phosphoric acid group or a sulfonic acid group is preferably used. It is preferred that the compound further has a polymerizable group in order to increase the adhesion property to the photosensitive layer. Also, a compound further having a hydrophilicity-imparting group, for example, an ethylene oxide group is exemplified as a preferable compound.

These compounds may be low molecular weight compounds or polymer compounds. For example, a silane coupling agent having an addition-polymerizable ethylenic double bond reactive group described in JP-A-10-282679 and a phosphorus-containing compound having an ethylenic double bond reactive group described in JP-A-2-304441 are preferably exemplified.

As the most preferable undercoat layer, an undercoat layer containing a low molecular weight compound or polymer compound having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263 is exemplified.

A coating amount (solid content) of the undercoat layer is preferably from 0.1 to 100 mg/m², and more preferably from 1 to 30 mg/m².

### <Backcoat layer>

A backcoat layer can be provided on the back surface of the hydrophilic support, if desired, after applying the surface treatment to the support or forming the undercoat layer on the support.

The backcoat layer preferably includes, for example, a coating layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### [Method of preparing lithographic printing plate]

The method of preparing a lithographic printing plate according to the invention is practiced by conducting an exposing step of exposing with laser the lithographic printing plate precursor described above, a developing step of removing the protective layer and the unexposed area of the photosensitive layer in the presence of a developer containing a specific organic solvent and at least one of a surfactant and a water-soluble polymer compound, and after the developing step, a drying step of drying the lithographic printing plate precursor by heating at a plate surface temperature in a range of 30 to 80°C. However, between the developing step and the drying step a water washing step is not conducted.

Each of the steps will be described in detail below.

### <Exposing step>

The exposing step is conducted by exposing imagewise the lithographic printing plate precursor with laser through a transparent original having a line image, a halftone dot image or the like, or exposing imagewise the lithographic printing plate precursor, for example, by scanning of laser beam based on digital data, in advance of the development processing.

The wavelength of the exposure light source is preferably from 300 to 450 nm or from 750 to 1,400 nm. In case of exposing with light of 300 to 450 nm, the lithographic printing plate precursor having a photosensitive layer containing a sensitizing dye having an absorption maximum in such a wavelength range is used. In case of exposing with light of 750 to 1,400 nm, the lithographic printing plate precursor containing an infrared absorbing agent which is a sensitizing dye having an absorption maximum in such a wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

### <Developing step>

A lithographic printing plate is prepared by exposing imagewise the lithographic printing plate precursor according to the invention and then performing development processing. In general, the development processing includes (1) a method of developing with an alkali developer (having pH higher than 11), (2) a method of developing with a developer having pH of 2 to 11, and (3) a method of developing (on-press development) by supplying dampening water and/or ink on a printing machine. According to the invention, (2) the method of developing with a developer having pH of 2 to 11 is preferred.

The developer according to the invention contains an organic solvent having a boiling point of 100°C or higher and an octanol-water partition coefficient of 3.0 or less and at least one of a surfactant and a water-soluble polymer compound. Since such an organic solvent well dissolves the materials of the photosensitive layer and is excellent in solubility in water, the occurrence of development scum caused by the hexaarylbisimidazole compound or monomer contained in the photosensitive layer is prevented so that good developing property, processing property and printing performance, for example, printing durability or ink-receptive property can be achieved.

The developer is preferably an aqueous solution containing water as a main component (containing 60% by weight or more of water). The pH of the developer is preferably from 2 to 11, more preferably from 5 to 10.7, still more preferably from 6 to 10.5, and most preferably from 6.9 to 10.3.

The developer may or may not contain an alkali agent. In the case of containing the alkali agent, the pH ranging from 9 to 11 is a preferred embodiment. The pH is more preferably from 9.3 to 10.5, and still more preferably from 9.4 to 10.2. In the case of not containing the alkali agent, the pH ranging from 2 to 9 is a preferred embodiment. The pH is more preferably from 4 to 8, and still more preferably from 4.5 to 7.5.

The organic solvent for use in the developer has a boiling point of 100°C or higher from the standpoint of preventing odor due to the volatilization thereof. The boiling point thereof is preferably from 100 to 300°C, and more preferably from 150 to 300°C.

Also, as the organic solvent has higher affinity to water, separation or volatilization of the organic solvent from the developer can be prevented. Thus, the octanol-water partition coefficient of the organic solvent is 3.0 or less, and preferably 1.0 or less. When the octanol-water partition coefficient of the organic solvent is too low, an ink-receptive property of a lithographic printing plate obtained is deteriorated. Thus, the lower limit of the octanol-water partition coefficient of the organic solvent is preferably - 2.0, more preferably -1.0, and still more preferably -0.5.

The octanol-water partition coefficient of the organic solvent can be determined by the method described in Japanese Industry Standard Z7260-107.

Examples of the organic solvent include an alcohol, an ester, an amido group-containing compound and a sulfur-containing compound.

The alcohol includes, for example, a straight-chain or branched alkyl alcohol having from 4 to 8 carbon atoms (preferably from 6 to 8 carbon atoms) (for example, 1-octanol, 1,4-butanediol, 1,5-pentanediol, 2-butene-1,4-diol, 2-methyl-2,4-pentanediol, 2-ethyl-1,3-hexanediol, 1,2,6-hexanetriol or 2-ethyl-2-(hydroxymethyl)-1,3-propanediol), a cyclic alkyl alcohol having from 5 to 8 carbon atoms (preferably from 5 to 7 carbon atoms) (for example, cyclohexanol, 2-methylcyclohexanol or tetrahydrofurfuryl alcohol), furfuryl alcohol, diacetone alcohol, and isobutyl alcohol.

The ester includes, for example, an ester having from 4 to 9 carbon atoms (for example, benzyl acetate, cyclohexyl acetate, butyl propionate, ethyl isovalerate, γ-butyrolactone, diethyl oxalate or diethyl malonate).

The amido group-containing compound includes, for example, formamide, N-methylformamide, N,N'-dimethylformamide, N,N'-diethylformamide, acetamide, N-methylacetamide, N,N'-dimethylacetamide, N-methylpropionamide, 2-pyrrolidone, N-methyl-2-pyrrolidone and caprolactam.

The sulfur-containing compound includes, for example, dimethylsulfoxide and sulfolane.

From the standpoint of easy dissolution of the polymerizable compound (B) described above, excellent solubility in water and high boiling point, the incorporation of the amido group-containing compound or sulfur-containing compound as the organic solvent is preferred and the incorporation of the amido group-containing compound is more preferred. Of the amido group-containing compounds, N-methylformamide, caprolactam, N-methyl-2-pyrrolidone, N,N'-dimethylformamide, N,N'-dimethylacetamide or N-methylpropionamide is more preferred. Of the sulfur-containing compounds, dimethylsulfoxide is more preferred. In particular, the combination of the polymerizable compound having a photo-oxidizable group (B) and the organic solvent described above is preferred because the compatibility between good printing durability and good developing property and processing property can be achieved.

Further, from the standpoint of easy dispersibility of the polymerizable compound (B) and stability in an acidic to neutral range, the alcohol or the ester is preferred, and the ester is particularly preferred. Of the esters, benzyl acetate, diethyl malonate or γ-butyrolactone is more preferred. Of the alcohols, 1-octanol, 2-methylcyclohexanol, cyclohexanol, furfuryl alcohol, diacetone alcohol, 1,4-butanediol or isobutyl alcohol is more preferred.

The amount of the organic solvent added to the developer is preferably from 0.001 to 2.0% by weight, more preferably from 0.001 to 0.05% by weight, and particularly preferably from 0.01 to 0.05% by weight. When the amount is 0.001% by weight or more, the dispersibility of the polymerizable compound in the developer can be improved and when the amount is 2.0% by weight or less, the odor can be further prevented.

The developer for use in the invention contains at least one of a surfactant and a water-soluble polymer compound.

The surfactant used in the developer includes, for example, an anionic, nonionic, cationic or amphoteric surfactant.

The anionic surfactant for use in the developer is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer is not particularly limited and includes, for example, alkylamine salts, quaternary ammonium salts, polyoxyethylene alkyl amine salts and polyethylene polyamine derivatives.

The nonionic surfactant for use in the developer is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred and alkyl-substituted or unsubstituted phenol ethylene oxide adducts and alkyl-substituted or unsubstituted naphthol ethylene oxide adducts are more preferred.

The amphoteric surfactant for use in the developer is not particularly limited and includes, for example, amine oxide type, for example, alkyldimethylamine oxide, betaine type, for example, alkyl betaine and amino acid type, for example, sodium salt of alkylamino fatty acid.

In particular, an alkyldimethylamine oxide which may have a substituent, an alkyl carboxy betaine which may have a substituent and an alkyl sulfo betaine which may have a substituent are preferably used. Specific examples of the compound are described, for example, in Paragraph Nos. [0255] to [0278] of JP-A-2008-203359 and Paragraph Nos. [0028] to [0052] of JP-A-2008-276166.

Two or more of the surfactants may be used in combination. The content of the surfactant in the developer is preferably from 0.01 to 20% by weight, and more preferably from 0.1 to 10% by weight.

The water-soluble polymer compound for use in the developer includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer and polystyrenesulfonic acid.

As the soybean polysaccharide, known soybean polysaccharide can be used. For example, as a commercial product, SOYAFIVE (trade name, produced by Fuji. Oil Co., Ltd.) is available and various grade products can be used. The soybean polysaccharide preferably used is that having viscosity in a range of 10 to 100 mPa/sec in the 10% by weight aqueous solution thereof.

As the modified starch, known modified starch can be used. The modified starch can be prepared, for example, by a method wherein starch, for example, of com, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

The developer for use in the invention may further contain a pH buffer agent.

As the pH buffer agent used in the invention, a buffer agent exhibiting a buffer function in a pH range of 2 to 11 is preferably used and a pH buffer agent functioning in a weak alkaline range is more preferably used. Specifically, for example, (a) a carbonate ion and a hydrogen carbonate ion, (b) a borate ion, (c) a water-soluble organic amine compound and an ion of the water-soluble organic amine compound, and combinations thereof are exemplified. Specifically, for example, (a) a combination of a carbonate ion and a hydrogen carbonate ion, (b) a borate ion, or (c) a combination of a water-soluble organic amine compound and an ion of the water-soluble organic amine compound exhibits a pH buffer function in the developer to prevent fluctuation of the pH even when the developer is used for a long period of time. As a result, for example, the deterioration of developing property resulting from the fluctuation of pH and the occurrence of development scum are restrained. The combination (a) of a carbonate ion and a hydrogen carbonate ion or the combination (c) of a water-soluble organic amine compound and an ion of the water-soluble organic amine compound is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof.

When the combination (a) of a carbonate ion and a hydrogen carbonate ion is adopted as the pH buffer agent, the total amount of the carbonate ion and hydrogen carbonate ion is preferably from 0.05 to 5 mol/l, more preferably from 0.1 to 2 mol/l, particularly preferably from 0.2 to 1 mol/l, in the developer.

The water-soluble organic amine compound and an ion of the water-soluble organic amine compound are not particularly restricted and the water-soluble organic amine compound is preferably selected from monoethanolamine, diethanolamine, triethanolamine, N-hydroxyethylmorpholine and 4-dimethylaminopyridine. These may be used in combination of two or more thereof. By using these, good developing property and processing stability are obtained even in a pH range close to neutral.

In the case of using the water-soluble organic amine compound, the amount used is preferably from 0.005 to 5 mol/l, more preferably from 0.01 to 2 mol/l, particularly preferably from 0.01 to 1 mol/l, in the developer.

The developer for use in the invention may contain a preservative, a chelating agent, a defoaming agent, an organic acid, an inorganic acid, an inorganic salt or the like in addition to the components described above. Specifically, compounds described in Paragraph Nos. [0266] to [0270] of JP-A-2007-206217 are preferably used.

In the developing step, the development processing is conducted using the developer described above.

The development processing can be performed in a conventional manner, for example, by a method wherein the exposed lithographic printing plate precursor is immersed in the developer and rubbed with a brush or a method wherein the developer is sprayed to the exposed lithographic printing plate precursor and the exposed lithographic printing plate precursor is rubbed with a brush. The development processing can be performed using an automatic development processing apparatus. The development processing by an automatic development processing apparatus is advantageous in view of being free from the measures against development scum resulting from the protective layer and/or photosensitive layer encountered in case of the on-press development (3). The temperature of development is ordinarily approximately from 0 to 60°C, preferably from 10 to 50°C, and more preferably from 15 to 40°C.

The developer described above can also be used as a development replenisher. In the case of performing the development processing using an automatic development processing apparatus, the developer becomes fatigued in accordance with the processing amount, and hence the processing ability may be restored using a replenisher or a fresh developer.

The development processing according to the invention is preferably performed by an automatic development processing apparatus equipped with a supplying means for the developer and a rubbing member. An automatic development processing apparatus using a rotating brush roll as the rubbing member is particularly preferred.

Further, the automatic development processing apparatus is preferably provided with a means for removing the excess developer, for example, a squeeze roller or a drying means, for example, a hot air apparatus, subsequently to the development processing means. Specific example of the automatic development processing apparatus is described below.

### <Drying step>

After the developing step, a drying step is conducted.

With respect to the drying step, a heating means is not particularly restricted and a heating means ordinarily used in the drying of such a lithographic printing plate precursor can be used without particular limitations. Specifically, the heating can be conducted, for example, with hot air, infrared ray or far-infrared ray.

The plate surface temperature of the lithographic printing plate precursor in the drying step is from 30 to 80°C, preferably from 40 to 80°C, more preferably from 50 to 80°C, and particularly preferably from 60 to 80°C. When the plate surface temperature is too low, the lithographic printing plate precursor is not sufficiently dried to cause a problem of stickiness or the like. When the plate surface temperature is too high, the volatile components volatilize so that odor generation is more likely to occur.

The plate surface temperature in the drying step means temperature in a position corresponding to the center on the processed side of the lithographic printing plate precursor immediately after the drying step. The plate surface temperature is temperature determined by noncontact measurement using a radiation thermometer. The heating time in the drying step is preferably from 1 to 20 seconds, and more preferably from 5 to 10 seconds.

It should be noted that a water washing step is not included between the developing step and the drying step in the method of preparing a lithographic printing plate according to the invention. Also, according to the invention, conventional development processing and gum solution treatment are possible to conduct with only one bath so that the processing steps can be remarkably simplified.

Moreover, a pre-water washing step is also not particularly necessary and removal of the protective layer is possible to conduct simulteniously with the development processing and gum solution treatment.

In the method of preparing a lithographic printing plate according to the invention, a lithographic printing plate can be prepared without conducting a water washing step between the development processing and a printing step as well as before the development processing. The printing step means a step starting with mounting of a lithographic printing plate on a printing machine.

Further, in the method of preparing a lithographic printing plate according to the invention, the entire surface of the lithographic printing plate precursor may be heated before the exposure, during the exposure or between the exposure and the development, if desired. By the heating, the image-forming reaction in the photosensitive layer is accelerated and advantages, for example, improvement in the sensitivity and printing durability and stabilization of the sensitivity may be achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions. Ordinarily, the heat treatment is carried out in a temperature range of 100 to 500°C. When the temperature is too low, the sufficient effect of strengthening the image may not be obtained, whereas when it is excessively high, problems of deterioration of the support and thermal decomposition of the image area may occur sometimes.

One example of the automatic development processing apparatus for use in the method of preparing a lithographic printing plate according to the invention is briefly described with reference to Fig. 1.

An automatic development processing apparatus 100 shown in Fig. 1 comprises a chamber the outer shape of which is formed by a machine casing 202 and has a pre-heating unit 200, a developing unit 300 and a drying unit 400 continuously formed along a transporting direction (arrow A) of a lithographic printing plate precursor 11.

The pre-heating unit 200 comprises a heating chamber 208 having a transporting inlet 212 and a transporting outlet 218 and a skewer roller 210, a heater 214 and a circulation fan 216 are arranged in the inside thereof.

The developing unit 300 is separated from the pre-heating unit 200 by an outer panel 310 and an insertion slot 312 of slit type is formed in the outer panel 310.

In the developing unit 300, a processing tank 306 having a developing tank 308 filled with a developer and a pair of insertion rollers 304 for guiding the lithographic printing plate precursor 11 into the processing tank 306 are disposed. A shielding cover 324 is located above the developing tank 308.

In the developing tank 308, a guide roller 344 and a guide member 342, a pair of submerged rollers 316, a pair of brush rollers 322, a pair of brush rollers 326 and a pair of carrying-out rollers 318 are provided in order from the upstream side of the transporting direction of lithographic printing plate precursor. The lithographic printing plate precursor 11 transported into the developing tank 308 is immersed in the developer and the non-image area is removed by passing between the pairs of rotating brush rollers 322 and 326.

A spray pipe 330 is provided under the pairs of brush rollers 322 and 326. The spray pipe 330 is connected to a pump (not shown) and the developer in the developing tank 308 sucked by the pump is ejected from the spray pipe 330 in the developing tank 308.

On a sidewall of the developing tank 308, an overflow aperture 51 is provided to form a top edge of a first circulation pipeline C1. The excess developer flows in the overflow aperture 51, passes through the first circulation pipeline C1 and is discharged in an external tank 50 provided outside the developing unit 300.

To the external tank 50 is connected a second circulation pipeline C2 and a filter unit 54 and a developer supply pump 55 are located in the second circulation pipeline C2. The developer is supplied from external tank 50 to the developing tank 308 by the developer supply pump 55. In the external tank 50, a level meter 52 and a level meter 53 are provided.

The developing tank 308 is also connected to a water tank 71 for replenishment through a third circulation pipeline C3. A water-replenishing pump 72 is located in the third circulation pipeline C3 and water pooled in the water tank 71 for replenishment is supplied to the developing bath 308 by the water-replenishing pump 72.

A liquid temperature sensor 336 is provided on the upstream side of the pair of submerged rollers 316. A liquid level meter 338 is provided on the upstream side of the pair of carrying-out rollers 318.

In a partition board 332 placed between the developing unit 300 and the drying unit 400, a pass-through slot 334 of slit type is formed. Also, a shutter (not shown) is provided along a passage between the developing unit 300 and the drying unit 400 and the passage is closed by the shutter when the lithographic printing plate precursor 11 does not pass through the passage.

In the drying unit 400, a support roller 402, ducts 410 and 412, a transport roller pair 406, ducts 410 and 412 and a transport roller pair 408 are disposed in this order. A slit hole 414 is provided at the top of each of the ducts 410 and 412. In the drying unit 400, a drying means (not shown), for example, a hot air supplying means or a heat generating means, is also provided. The drying unit 400 has a discharge slot 404 and the resulting lithographic printing plate dried by the drying means is discharged through the discharge slot 404.

### [Example]

The present invention will be described in more detail with reference to the following examples and comparative examples, but the invention should not be construed as being limited thereto.

### Examples 1 to 26 and Comparative Examples 1 to 8

### [Preparation of Lithographic printing plate precursor (1)]

### <Preparation of Support>

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The degreased aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate thus-treated was subjected to an anodizing treatment under condition of current density of 10 A/dm² and voltage of 15 V in an aqueous 15% by weight sulfuric acid solution at 25°C for one minute and then subjected to a hydrophilization treatment using an aqueous 1% by weight polyvinylphosphonic acid solution at 75°C to prepare a support. The surface roughness of the support was measured and found to be 0.44 µm (Ra indication according to JIS B0601).

### <Formation of Photosensitive layer 1>

Coating solution (1) for photosensitive layer having the composition shown below was coated on the support using a bar and dried in an oven at 90°C for 60 seconds to form Photosensitive layer 1 having a dry coating amount of 1.3 g/m².

### Coating solution (1) for photosensitive layer

· Binder Polymer (1) shown below (weight average molecular weight: 50,000) 0.04 g
· Binder Polymer (2) shown below (weight average molecular weight: 80,000) 0.30 g
· Polymerizable Compound (1) shown below 0.17 g
(PLEX 6661-O, produced by Degussa Japan Co. Ltd.)
· Polymerizable Compound (2) shown below 0.51 g
· Sensitizing Dye (1) shown below 0.03 g
· Sensitizing Dye (2) shown below 0.015 g
· Sensitizing Dye (3) shown below 0.015 g
· Polymerization Initiator (1) shown below 0.13 g
· Chain Transfer Agent: Mercaptobenzothiazole 0.01 g
· Dispersion of ε-phthalocyanine pigment 0.40 g
   (Pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight)
· Thermal polymerization inhibitor 0.01 g N-nitrosophenylhydroxylamine aluminum salt
· Fluorine-Based Surfactant (1) shown below (weight average molecular weight: 10,000) 0.001 g
· 1-Methoxy-2-propanol 3.5 g
· Methyl ethyl ketone 8.0 g

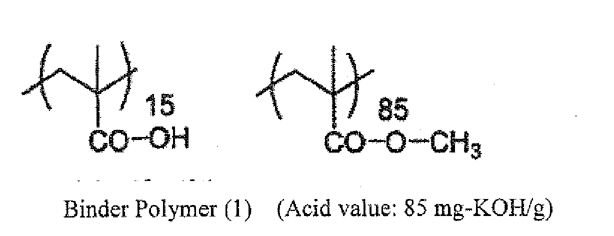

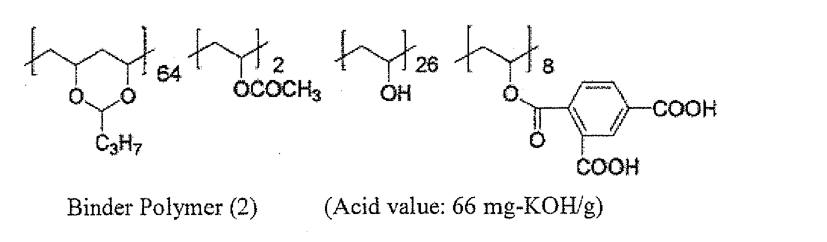

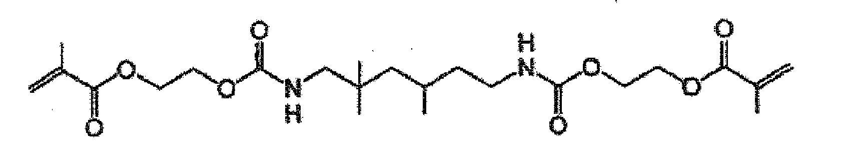

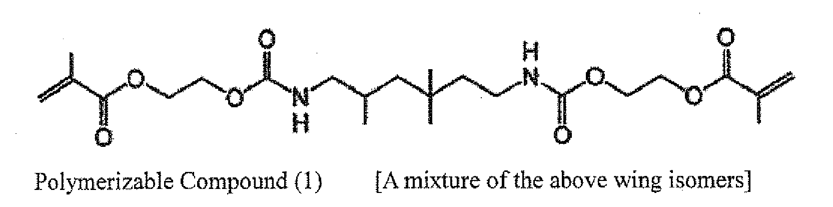

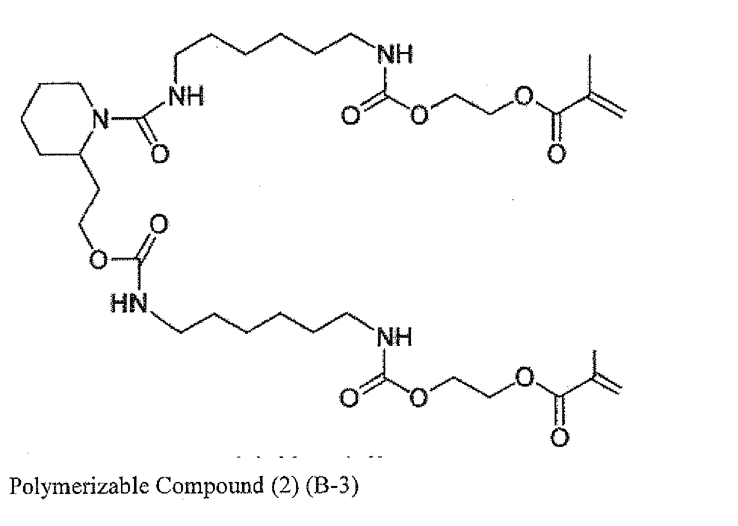

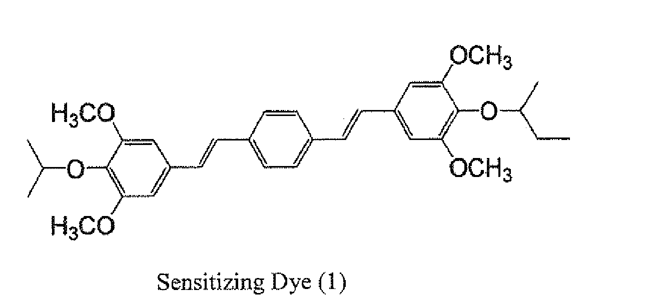

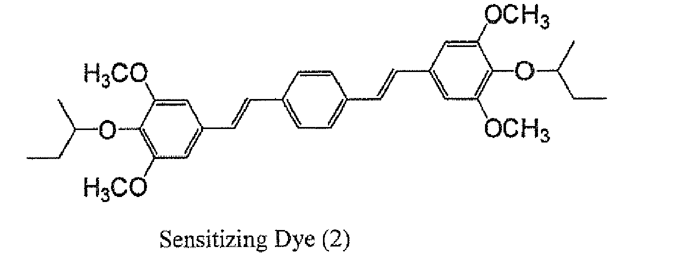

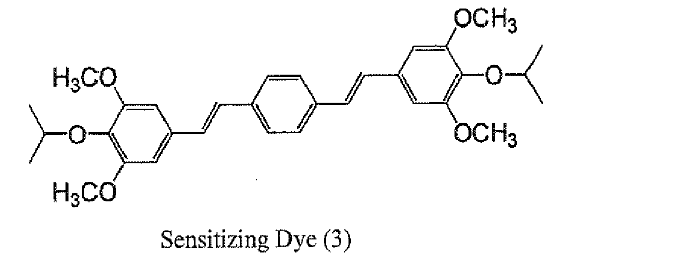

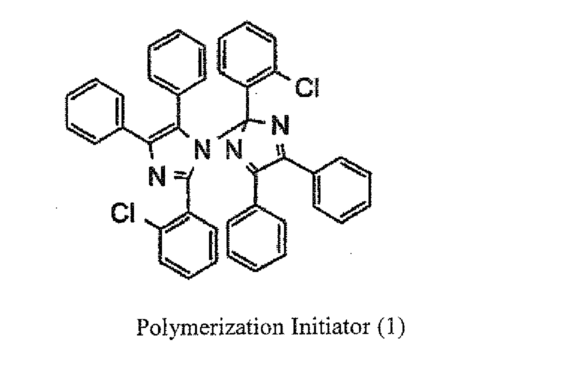

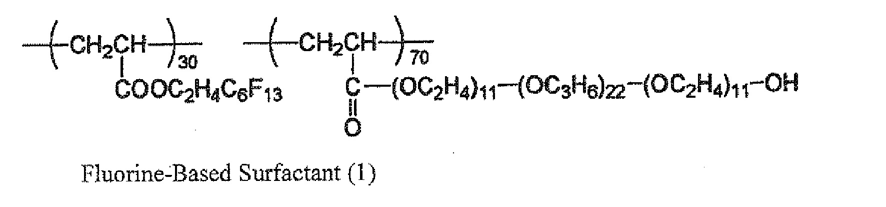

### <Formation of Protective layer 1>

Coating solution (1) for protective layer having the composition shown below was coated on Photosensitive layer 1 using a bar so as to have a dry coating amount of 1.2 g/m² and dried at 125°C for 70 seconds to from Protective layer 1, thereby preparing Lithographic printing plate precursor (1).

### Coating solution (1) for protective layer

· PVA-205 0.658 g
(partially hydrolyzed polyvinyl alcohol, produced by Kuraray Co., Ltd. (saponification degree: 86.5 to 89.5% by mol; viscosity: 4.6 to 5.4 mPa·s in a 4% by weight aqueous solution at 20°C))
· PVA-105 0.142 g
(fully hydrolyzed polyvinyl alcohol, produced by Kuraray Co., Ltd. (saponification degree: 98.0 to 99.0% by mol; viscosity: 5.2 to 6.0 mPa·s in a 4% by weight aqueous solution at 20°C))
· Vinyl pyrrolidone/vinyl acetate (1/1) copolymer
(weight average molecular weight: 70,000) 0.001 g
· Surfactant (EMALEX 710, produced by Nihon Emulsion Co., Ltd.) 0.002 g
· Water 13 g

### [Preparation of Lithographic printing plate precursor (2) for comparison]

Lithographic printing plate precursor (2) for comparison was prepared in the same manner as in Lithographic printing plate precursor (1) expect for changing Polymerizable compound (2) in Photosensitive layer (1) to dipentaerythritol hexaacrylate.

### [Exposure, Development and Printing]

Each of Lithographic printing plate precursors (1) and (2) was subjected to image exposure by a violet semiconductor laser plate setter Vx9600 (having InGaN semiconductor laser: emission: 405 nm ± 10 nm/output: 30 mW) produced by FUJIFILM Electronic Imaging, Ltd. As for the image, halftone dots of 50% were drawn using an FM screen (TAFFETA 20, produced by FUJIFILM Corp.) in a plate surface exposure amount of 0.05 mJ/cm² and at resolution of 2,438 dpi.

The exposed lithographic printing plate precursor was then subjected to development processing in an automatic development processing apparatus having a structure shown in Fig. 1 using Developer (1) having the composition shown below at transporting speed so as to have pre-heating time of 10 seconds at 100°C and immersion time (developing time) in the developer (having temperature of 25°C) of 20 seconds. The temperature of a position corresponding to the center of the lithographic printing plate precursor immediately after passing the drying unit was controlled so as to have the temperature shown in Table 1 which was determined by noncontact measurement using a radiation thermometer. The heating time (time for passing through the drying unit) was 7.4 seconds.

The lithographic printing plate obtained by the development processing was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

### Developer (1)

· Water 88.6 g
· Nonionic Surfactant (W-1) shown below 2.4 g
· Nonionic Surfactant (W-2) shown below 2.4 g
· Nonionic Surfactant (EMALEX 710, produced by Nihon Emulsion Co., Ltd.) 1.0 g
· Organic solvent shown in Table 1 Amount shown in Table 1
· N-(2-Hydroxyethyl)morpholine 1.0 g
· Triethanolamine 0.5 g
· Sodium gluconate 1.0 g
· Trisodium citrate 0.5 g
· Tetrasodium ethylenediaminetetraacetate 0.05 g
· Polystyrenesulfonic acid (VERSA TL77 (30% by weight solution), produced by Alco Chemical Inc.) 1.0 g

The pH was adjusted by adding sodium hydroxide and phosphoric acid to the developer of the above composition.

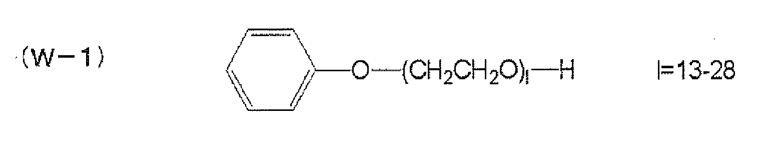

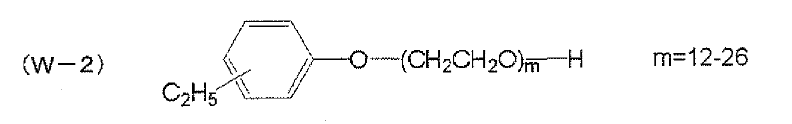

### [Evaluation]

### <Odor>

The lithographic printing plate precursor was subjected to the image exposure and development processing as described above and after the drying, odor of the resulting lithographic printing plate was evaluated. Specifically, the odor was evaluated using sensory testing (whether the odor was strongly recognized or it was ignored) by 10 operators according to the criteria described below.
A: 7 or more of the 10 operators recognized that the odor was ignored.
B: 4 to 6 of the 10 operators recognized that the odor was ignored.
C: 3 or less of the 10 operators recognized that the odor was ignored.

### <Developing property>

The lithographic printing plate precursor was subjected to the image exposure and development processing as described above. The non-image area of the lithographic printing plate obtained by the development processing was visually observed and the residue of the photosensitive layer was evaluated according to the criteria described below.

A: Good developing property where the residue of photosensitive layer was not present.

B: No problem in the developing property, although the slight residue of photosensitive layer was present.

C: The photosensitive layer remained to cause development failure.

### <Ink-receptive property>

The lithographic printing plate was subjected to the printing as described above. On the 100^{th} printed material, the ink density in the image area was evaluated according to the criteria described below.
A: Unevenness of the ink density in the image area was not present.
B: Slight unevenness of the ink density in the image area was present.
C: Unevenness of the ink density in the image area was present or the image was not obtained because ink did not attach.

### <Processing property>

After the lithographic printing plate precursor was subjected to development processing using the automatic development processing apparatus as described above in an amount of 500 m², the generation of scum adhered on the tank wall of the automatic development processing apparatus was observed and evaluated according to the criteria described below.
A: The generation of scum was not observed.
B: The generation of scum was slightly observed.
C: The generation of scum was observed, but was in an acceptable level.
D: The generation of scum was severe.

### <Printing durability>

As increase in the number of printed materials, the image of the photosensitive layer formed on the lithographic printing plate was gradually abraded to cause decrease in the ink-receptive property, resulting in decrease in ink density of the image on a printing paper. A number of printed materials obtained until the ink density (reflection density) decreased by 0.1 from that at the initiation of printing was determined to evaluate the printing durability. Also, the printing durability in the case where the pre-heating was not conducted in the automatic development processing apparatus was evaluated.

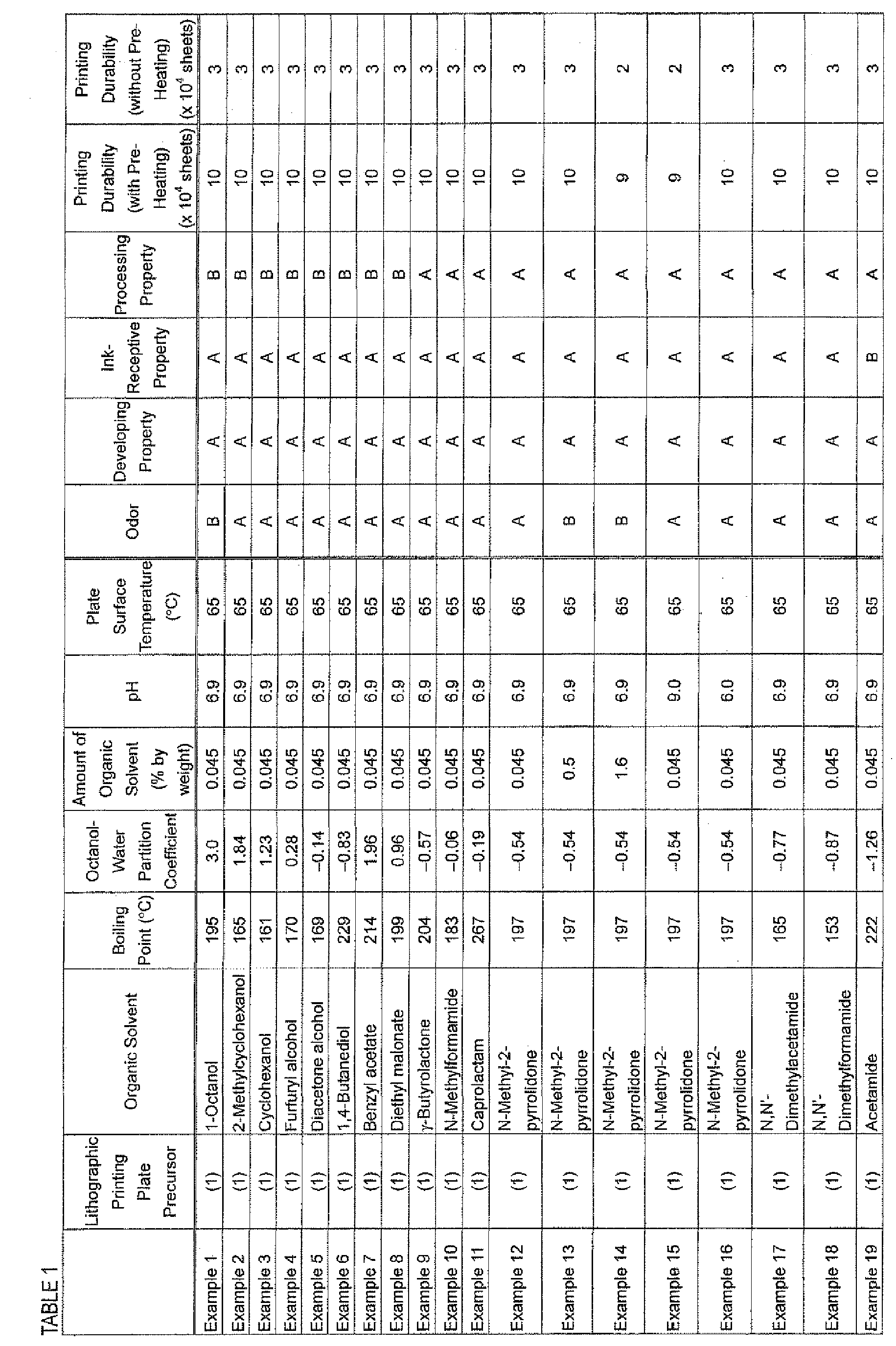

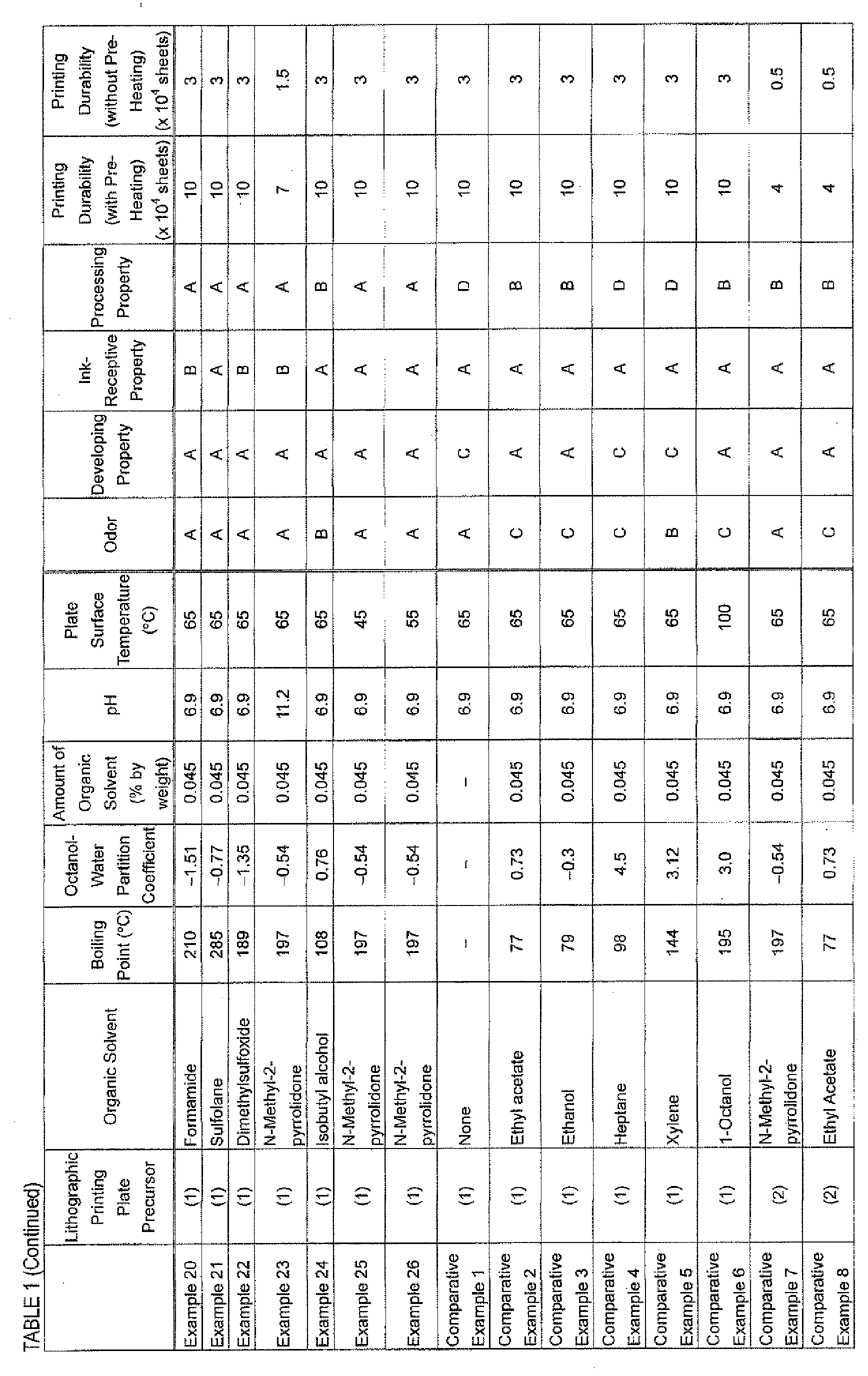

### Examples 27 to 52 and Comparative Examples 9 to 16

Each of Lithographic printing plate precursors (1) and (2) was subjected the image exposure, development processing and printing in the same manner as in Examples 1 to 26 except for using Developer (2) having the composition shown below in place of Developer (1) to prepare a lithographic printing plate. The resulting lithographic printing plate was evaluated in the same manner as in Examples 1 to 26.

### Developer (2)

· Surfactant (1) (SOFTAZOLINE LPB-R, produced by Kawaken Fine Chemicals Co, Ltd.) 15 g
· Surfactant (2) (SOFTAZOLINE LAO, produced by Kawaken Fine Chemicals Co, Ltd.) 4 g
· Organic solvent shown in Table 2 Amount shown in Table 2
· Chelating agent: Trisodium ethylenediaminesuccinate (OCTAQUEST E30, produced by Innospec Specialty Chemicals Inc.) 0.68 g
· 2-Bromo-2-nitropropane-1,3-diol 0.025 g
· 2-Methyl-4-isothiazoline-3-one 0.025 g
· Silicone type deforming agent: (TSA 739, produced by GE Toshiba Silicone Co., Ltd.) 0.15 g
·Sodium gluconate 1.5 g
·Sodium carbonate 1.06 g
· Sodium hydrogen carbonate 0.52 g
· Water 77.04 g

The pH was adjusted by adding sodium hydroxide and phosphoric acid to the developer of the above composition.

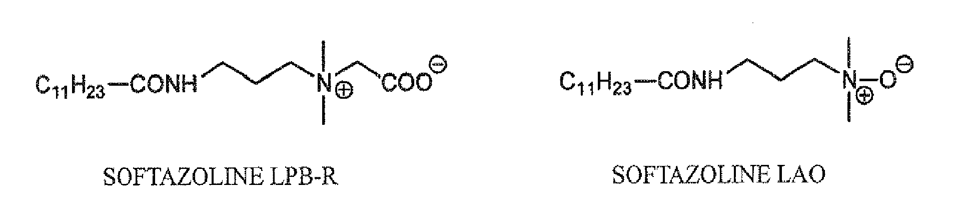

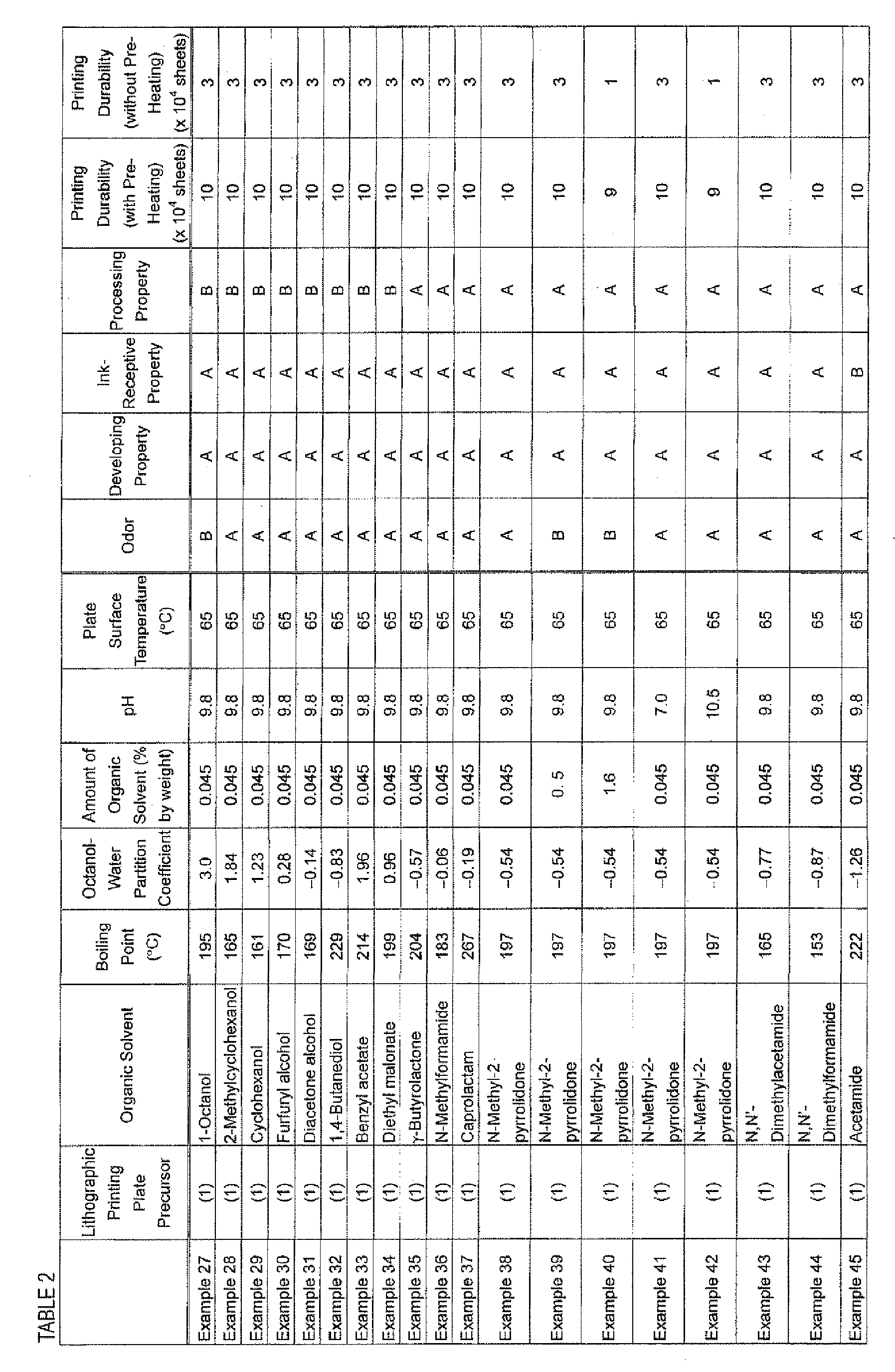

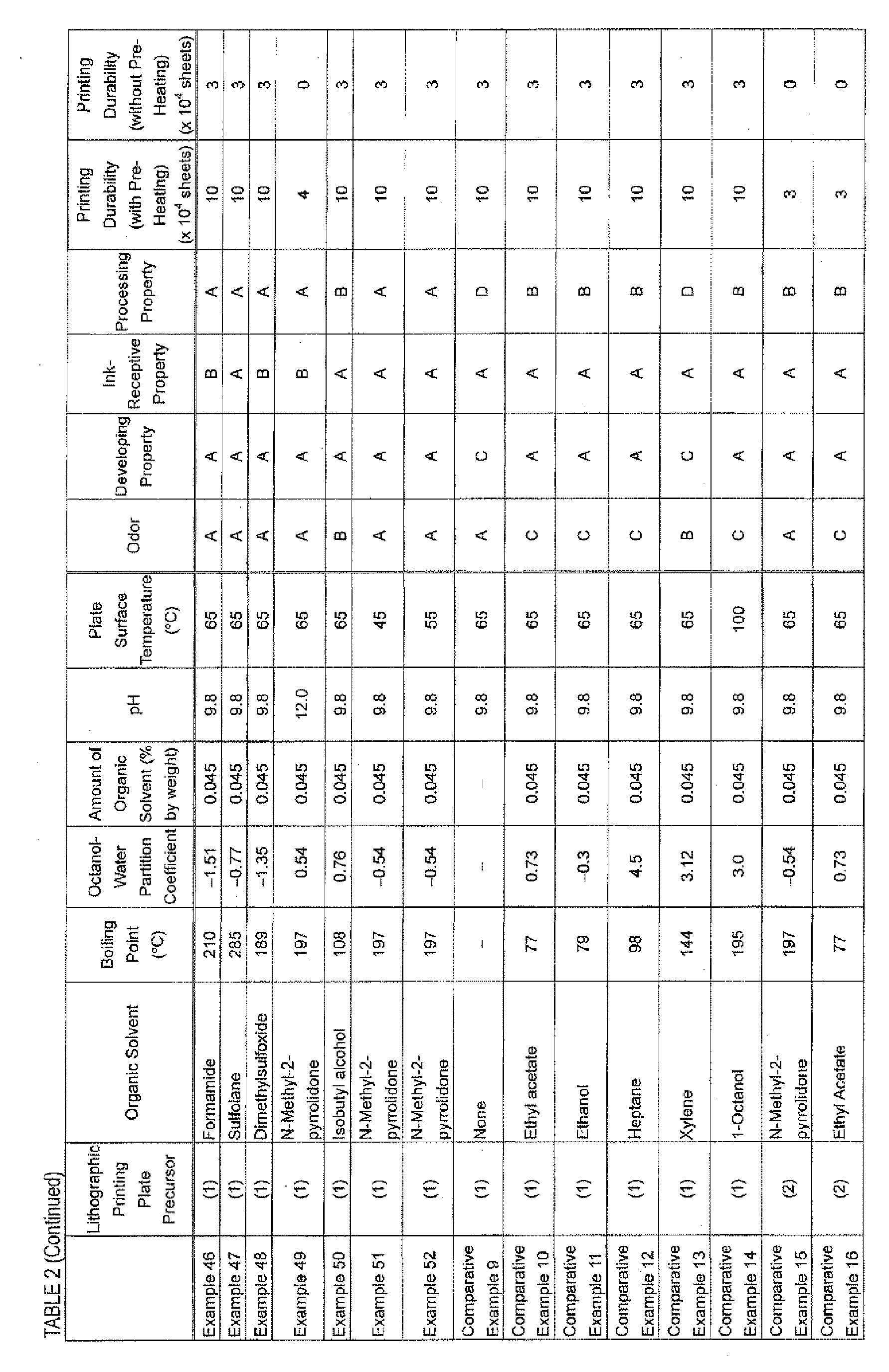

As is apparent from Tables 1 and 2, it is possible to prepare a lithographic printing plate which is excellent in odor, developing property, ink-receptive property and processing property in accordance with a method of preparing a lithographic printing plate of the present invention comprising an exposing step of exposing with laser a lithographic printing plate precursor comprising a hydrophilic support having provided thereon a photosensitive layer containing a hexaarylbisimidazole compound, a polymerizable compound having a photo-oxidizable group, a sensitizing dye and a binder polymer and a protective layer in this order, a developing step of removing the protective layer and an unexposed area of the photosensitive layer in the presence of a developer containing an organic solvent having a boiling point of 100°C or higher and an octanol-water partition coefficient of 3.0 or less and at least one of a surfactant and a water-soluble polymer compound, and, after the above developing step, a drying step of drying the lithographic printing precursor by heating at a plate surface temperature in a range of 30 to 80°C, wherein a water washing step is not included between the developing step and the drying step.

On the contrary, it is noted that the developing property is inferior when no organic solvent is contained, that the odor is inferior when a boiling point of the organic solvent is lower than 100°C or a plate temperature is 80°C or higher and that the odor or the developing property is inferior when an octanol-water partition coefficient is more than 3.0.

The entire disclosure of Japanese Patent Application No. 2009-219715 filed on September 24, 2009, from which the benefit of foreign priority has been claimed in the present application, is incorporated herein by reference, as if fully set forth.

## Claims

1. A method of preparing a lithographic printing plate , which comprises:
an exposing step of exposing with laser a lithographic printing plate precursor comprising a hydrophilic support having provided thereon a photosensitive layer containing (A) a hexaarylbisimidazole compound, (B) a polymerizable compound having a photo-oxidizable group, (C) a sensitizing dye and (D) a binder polymer, and a protective layer in this order,
a developing step of removing the protective layer and an unexposed area of the photosensitive layer of the lithographic printing plate precursor in the presence of a developer containing an organic solvent having a boiling point of 100°C or higher and an octanol-water partition coefficient of 3.0 or less and at least one of a surfactant and a water-soluble polymer compound, and
a drying step of drying the lithographic printing plate precursor by heating at a plate surface temperature in a range of 30 to 80°C,
wherein a water washing step is not included between the developing step and the drying step.

2. The method of preparing a lithographic printing plate according to claim 1, wherein a pH of the developer is from 2 to 11.

3. The method of preparing a lithographic printing plate according to claim 1 or 2, wherein the developer further contains a carbonate ion and a hydrogen carbonate ion.

4. The method of preparing a lithographic printing plate according to claim 1 or 2, wherein the developer further contains a water-soluble organic amine compound and an ion of the water-soluble organic amine compound.

5. The method of preparing a lithographic printing plate according to claim 4, wherein the water-soluble organic amine compound is at least one organic amine compound selected from the group consisting of monoethanolamine, diethanolamine, triethanolamine, N-hydroxyethylmorpholine and 4-dimethylaminopyridine.

6. The method of preparing a lithographic printing plate according to any one of claims 1 to 5, wherein the organic solvent is an alcohol.

7. The method of preparing a lithographic printing plate according to any one of claims 1 to 5, wherein the organic solvent is an ester.

8. The method of preparing a lithographic printing plate according to any one of claims 1 to 5, wherein the organic solvent is an amido-group containing compound.

9. The method of preparing a lithographic printing plate according to any one of claims 1 to 5, wherein the organic solvent is a sulfur-containing compound.

10. The method of preparing a lithographic printing plate according to any one of claims 1 to 9, wherein an amount of the organic solvent is from 0.001 to 2.0% by weight in the developer.

11. The method of preparing a lithographic printing plate according to any one of claims 1 to 10, wherein (D) the binder polymer is a polyvinyl butyral resin.
